# EUROPEAN PATENT APPLICATION

(11) **EP 3 799 113 A1**
(43) Date of publication of application: **31.03.2021**
(21) Application number: 19807564.0
(22) Date of filing: 28.03.2019
(51) Int. Cl.: H01L 23/08, H01L 23/12

(54) **CERAMIC PACKAGE FOR FILLING LIQUID-COMPONENT CONTAINING ELECTROLYTE**

(30) Priority: 21.05.2018 JP 2018096813
(71) Applicant: NGK Spark Plug Co., Ltd., Nagoya-shi, Aichi 467-8525 (JP)
(72) Inventor: MIYAJI Takayuki, Nagoya-shi, Aichi 467-8525 (JP)
(74) Representative: Grünecker Patent- und Rechtsanwälte PartG mbB
(86) International application number: PCT/JP2019/013674
(87) International publication number: WO 2019/225152

(57) **Abstract**

The present invention provides a ceramic package for filling a liquid-component containing electrolyte, which is resistant to development of corrosion due to the electrolyte to an outer side of a cavity even though the electrolyte fills the cavity. Package 1a has ceramic substrate body 2 having front and back surfaces 3, 4 and side surface 5 between these surfaces, cavity 6 opening on front surface 3 and having bottom surface 7 and inner side surface 8, electrode pad 9 formed on bottom surface 7, external connecting terminal 10 formed on back surface 4, electronic component 14 mounted on electrode pad 9 and electrolyte 16 filling cavity 6. Electrode pad 9 and external connecting terminal 10 are electrically connected to each other through via conductor 12 penetrating ceramic layer c1 forming bottom surface 7 of cavity 6 and back surface 4 of substrate body 2. Side surface conductor 17 is provided on side surface 5 of substrate body 2, and side surface conductor 17 and external connecting terminal 10 are connected to each other. Electrode pad 9 and side surface conductor 17 are separate from each other.

## Description

### TECHNICAL FIELD

The present invention relates to a ceramic package for filling a liquid-component containing electrolyte, which mounts an electronic component in a cavity opening on a surface of a ceramic substrate body of the ceramic package and surrounds the electronic component with the electrolyte containing liquid-component such as a gel electrolyte which fills the cavity.

### BACKGROUND ART

As a ceramic package in which a ceramic frame body is stacked at a peripheral side on an upper surface of a flat plate-shaped ceramic base then a cavity that opens upward is formed, there has been proposed, for instance, a ceramic package having an arc-shaped cutting portion that is formed by cutting at least one of arc-shaped angle portions (arc-shaped inner corner portions when viewed from above) of the cavity in a direction of an outer peripheral side when viewed from above and a castellation conductor that extends in an up-and-down direction along an inner wall surface of the cutting portion (e.g. Patent Document 1).

According to the above ceramic package, it is possible to improve electrical reliability of paths from four conductor pads provided at four corner sides of a bottom surface of the cavity to other castellation conductors formed on outer side surfaces of the ceramic base through interlayer conductor portions provided between the ceramic base and the ceramic frame body and extending in the direction of the outer peripheral side.

On the other hand, the above ceramic package can also be used as a battery or an electrochemical cell by mounting electronic component(s) such as a capacitor on the four conductor pads in the cavity, filling a space around the electronic component(s) in the cavity with a liquid or gel electrolyte and hermetically sealing an opening of the cavity.

However, due to the fact that the electrolyte contacts a metal part such as tungsten that forms the conductor pad from thinner portions of a nickel layer and a gold layer with which an exposed surface of the conductor pad is coated by plating, corrosion might appear, and also such corrosion might reach the other castellation conductor formed on the outer side surface of the ceramic base through the interlayer conductor portion. As a result, if the corrosion develops, a leakage path is generated at the interlayer conductor arranged between the ceramic layers, then there arises a problem of impairing air-tightness between inner and outer sides of the cavity of the ceramic package.

### CITATION LIST

### PATENT DOCUMENT

Patent Document 1: Japanese Unexamined Patent Application Publication No. JP2010-287652 (Pages 1 to 10, Figs. 1 to 4)

### SUMMARY OF THE INVENTION

An object of the present invention is therefore to provide a ceramic package for filling the liquid-component containing electrolyte which can solve the problem explained in the above background art and which is resistant to the development of a corroded portion, caused by the contact of the electrolyte with the metal part, to the outer side of the cavity even though the liquid-component containing electrolyte fills the cavity.

### SOLUTION TO PROBLEM AND EFFECTS OF INVENTION

In order to solve the above problem, the present invention was made with an idea that electrical connection between an electrode pad formed on a bottom surface of a cavity that opens on a front surface of a ceramic substrate body and an external connecting terminal formed on a back surface of the substrate body is established only through a via conductor that penetrates a single or a plurality of ceramic layers forming the bottom surface of the cavity and the back surface of the substrate body.

That is, a ceramic package for filling a liquid-component containing electrolyte (claim 1) comprises: a substrate body formed by stacking a plurality of ceramic layers and having a front surface and a back surface that are located at opposite sides to each other and a side surface that is positioned between the front and back surfaces; a cavity opening on the front surface of the substrate body and having a bottom surface and an inner side surface; an electrode pad formed on the bottom surface of the cavity; an external connecting terminal formed on the back surface of the substrate body; an electronic component mounted on the electrode pad; and the liquid-component containing electrolyte filling an inside of the cavity including a space around the electronic component. And, the electrode pad and the external connecting terminal are electrically connected to each other through a via conductor that penetrates, in a thickness direction, a single or a plurality of ceramic layers forming the bottom surface of the cavity and the back surface of the substrate body, a side surface conductor that extends to a back surface-side end portion of the side surface is provided on the side surface of the substrate body, the external connecting terminal extends to a side surface-side end portion of the back surface of the substrate body, and the back surface-side end portion of the side surface conductor and the side surface-side end portion of the external connecting terminal are connected to each other, and the electrode pad and the side surface conductor are separate from each other.

According to the above ceramic package, it is possible to obtain the following effects (1) to (3).
(1) The electrode pad and the external connecting terminal are electrically connected to each other only through the via conductor, and the plurality of ceramic layers are directly connected to each other at an outer peripheral side of the bottom surface of the cavity on the same plane as the bottom surface. That is, the side surface conductor and the electrode pad are not connected at the side surface of the substrate body. As a result, a situation in which a leakage path caused by corrosion due to the electrolyte is generated at the side surface of the substrate body can be avoided or suppressed. It is therefore possible to prevent the liquid-component containing electrolyte, which fills the cavity so as to surround the electronic component mounted in the cavity, from leaking to an outside portion of the side surface etc. of the substrate body.
(2) By and according to the effect (1), it is possible to ensure reliability of the electronic component such as a capacitor mounted on the electrode pad provided on the bottom surface of the cavity.
(3) Since the side surface-side end portion of the external connecting terminal and the back surface-side end portion of the side surface conductor are connected to each other, in addition to the effect (1), connecting reliability when mounting the ceramic package on a printed board can be adequately ensured.

Here, ceramic of the ceramic layer is a high temperature co-fired ceramic such as alumina or a low temperature co-fired ceramic such as glass-ceramic.

Further, when the ceramic of the ceramic layer is alumina etc., the electrode pad, the external connecting terminal, the via conductor and an internal layer wiring are made of tungsten (hereinafter, simply referred to as W) or molybdenum (hereinafter, simply referred to as Mo), whereas when the ceramic of the ceramic layer is glass-ceramic etc., they are made of copper (Cu) or silver (Ag) .

Although the front surface and the back surface of the substrate body (package body) are rectangular (a rectangle or a square) in shape, their shapes are not limited to the rectangular shape.

As the electronic component, for instance, it is a capacitor.

Although the electrode pad has, for instance, a rectangular shape in plan view, the shape of the electrode pad is not limited to the rectangular shape.

The electrode pads could be connected to a plurality of external connecting terminals in parallel through a plurality of via conductors.

A cross section along a radial direction of the via conductor is one of a circle, an ellipse, an oval and a rectangle.

The liquid-component containing electrolyte contains a gel component or a liquid component. The liquid-component containing electrolyte contains, for instance, ionized Na, ionized K, ionized Ca, ionized P, ionized Cl etc.. More specifically, it is, for instance, a solution obtained by dissolving a lithium salt such as lithium tetrafluoroborate and an acid such as hydrochloric acid, sulfuric acid and nitric acid in an organic solvent such as dimethoxyethane and propylene carbonate.

A gel electrolyte is a liquid electrolyte impregnated with polymer gel. The polymer gel includes polyethylene oxide, polymethyl methacrylate, polyvinylidene fluoride, and the like. Alternatively, pyridine-based ionic liquid, cyclic amine-based ionic liquid, aliphatic amine-based ionic liquid or imidazolium-based ionic liquid or amidine-based room temperature molten salt may be used.

In addition, the above ceramic package can be applied to a package (a large-sized package) having a plurality of ceramic packages which is formed by a product region having a plurality of packages that are adjacently arranged laterally and longitudinally in plan view and ear sections formed by stacked ceramic layers and enclosing the product region.

The present invention also includes the ceramic package for filling the liquid-component containing electrolyte (claim 2) in which the electrode pad has, as a part of the electrode pad, an entry portion that extends between a lower layer-side ceramic layer forming the bottom surface of the cavity and an upper layer-side ceramic layer stacked on the lower layer-side ceramic layer, and the lower layer-side ceramic layer and the upper layer-side ceramic layer are directly connected to each other at an outer peripheral side, in plan view, of the entry portion except the entry portion.

According to the above ceramic package, although the electrode pad has, as a part of the electrode pad, the entry portion extending between the ceramic layers, the ceramic layers are directly connected to each other at the outer peripheral side of the entry portion (at an outer side of a periphery of the entry portion) . It is therefore possible to obtain not only the effects (1) to (3) but also the following effect (4).

(4) Since the electrode pad has, as a part of the electrode pad, the entry portion, even the electrode pad having a relatively large area in plan view can be easily placed on the bottom surface of the cavity and at a peripheral side of the bottom surface. This can consequently contribute to reduction in whole size of the ceramic package, and also degree of flexibility in position of the via conductor electrically connected to the external connecting terminal provided on the back surface of the substrate body can be increased.

The present invention further includes the ceramic package for filling the liquid-component containing electrolyte (claim 3) in which the cavity is rectangular in shape in plan view, and a pair of electrode pads are formed at one side of the cavity, or a pair of electrode pads are formed at opposing two sides of the cavity respectively.

According to the above ceramic package, in addition to each effect described above, it is possible to obtain the following effect (5).

(5) An electronic component such as a capacitor having two electrodes can be efficiently placed on the bottom surface, which has a relatively small area in plan view, of the cavity.

Here, the rectangular shape includes a rectangle, a square, a rectangle having four round corners and a square having four round corners.

Further, as for the electrode pad, four electrode pads each having the entry portion can be provided at four corner sides on the bottom surface of the cavity.

The present invention includes the ceramic package for filling the liquid-component containing electrolyte (claim 4) in which the substrate body has an internal layer wiring that is formed between a lower layer-side ceramic layer forming the bottom surface of the cavity and a lowermost ceramic layer forming the back surface of the substrate body, and the via conductor is connected to the electrode pad and the external connecting terminal through the internal layer wiring.

According to the above ceramic package, in addition to each effect described above, it is possible to obtain the following effect (6).

(6) Since the via conductor is electrically connected to the electrode pad and the external connecting terminal through the internal layer wiring, degree of flexibility in design for plan view arrangement of the electrode pad and the external connecting terminal can be further increased.

### BRIEF DESCRIPTION OF THE DRAWINGS

Fig. 1A is a plan view of a ceramic package according to an embodiment of the present invention. Fig. 1B is a cross section vertically cut by a plane passing through a B-B line of Fig. 1A.
Fig. 2A is a plan view of a ceramic package according to an embodiment that is different from the above embodiment. Fig. 2B is a cross section vertically cut by a plane passing through a B-B line of Fig. 2A.
Fig. 3A is a plan view of a ceramic package according to an application embodiment of the package of Fig. 1A.
Fig. 3B is a cross section vertically cut by a plane passing through a B-B line of Fig. 3A.
Fig. 4A is a plan view of a ceramic package according to an application embodiment of the package of Fig. 2A.
Fig. 4B is a cross section vertically cut by a plane passing through a B-B line of Fig. 4A.
Figs. 5A and 5B are plan views of ceramic packages according to other embodiments . Figs. 5C and 5D are local sectional views showing vertically-cut external connecting terminals and their vicinities according to other embodiments.
Fig. 6A is a plan view of a multiple ceramic package having a plurality of ceramic packages of Fig. 1A. Fig. 6B is a cross section vertically cut by a plane passing through a B-B line of Fig. 6A.

### EMBODIMENTS FOR CARRYING OUT THE INVENTION

Embodiments of the present invention will be explained below with reference to the drawings.

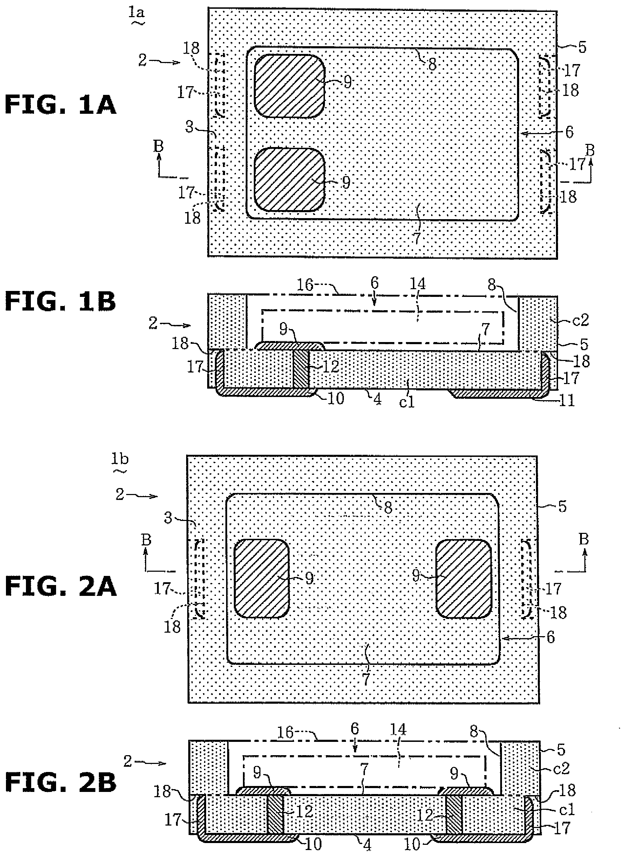

Fig. 1A is a plan view of a ceramic package 1a for filling a liquid-component containing electrolyte according to an embodiment of the present invention. Fig. 1B is a cross section vertically cut by a plane passing through a B-B line of Fig. 1A.

As shown in Figs. 1A and 1B, the ceramic package for filling the liquid-component containing electrolyte (hereinafter, simply called a package) 1a has a substrate body 2 having a front surface 3 and a back surface 4 which are rectangular in shape in plan view (or when viewed from above) and located at opposite sides to each other and four side surfaces 5 which are positioned at four sides between the front surface 3 and the back surface 4, a cavity 6 opening on the front surface 3 and having a bottom surface 7 which is rectangular in shape in plan view and an inner side surface 8 which stands from four sides of the bottom surface 7, a pair of (two) electrode pads 9 formed along a left shorter side in plan view on the bottom surface 7 of the cavity 6, a pair of (two) external connecting terminals 10 formed on the back surface 4 of the substrate body 2 below the respective electrode pads 9, and a pair of mounting back surface conductors (hereinafter, simply called back surface conductors) 11 formed on the back surface 4 at an opposite side to the external connecting terminals 10.

As shown in Fig. 1B, the substrate body 2 is formed by integrally connecting a flat plate-shaped ceramic layer c1 and a rectangular frame-shaped ceramic layer c2 that is stacked on an upper surface of the ceramic layer c1 along a peripheral side of the ceramic layer c1. The ceramic layers c1 and c2 are made of, e.g. alumina, aluminium nitride or mullite as a main component.

The electrode pads 9 and the respective external connecting terminals 10 have electrical continuity (the electrode pads 9 and the respective external connecting terminals 10 are electrically connected to each other) through a pair of via conductors 12 that penetrate the lower layer-side ceramic layer c1. Here, in Fig. 1B, the pair of via conductors 12 overlap each other when viewed in a front-rear direction.

Two rectangular parallelopiped-shaped recessed portions 18 located or extending from the side surface 5 to the back surface 4 are formed on the right and left side surfaces 5 respectively, in plan view, of the substrate body 2. Further, a pair of side surface conductors 17 whose back surface-side end portions are connected to respective side surface-side end portions of the pair of external connecting terminals 10 extend on recessed inner wall surfaces, which are parallel to the side surfaces 5, of the recessed portions 18 located at the left side surface 5.

In addition, a pair of side surface conductors 17 whose back surface-side end portions are connected to respective side surface-side end portions of the pair of back surface conductors 11 extend on recessed inner wall surfaces of the recessed portions 18 located or extending from the right side surface 5 to the back surface 4, in plan view, of the substrate body 2.

The electrode pad 9, the external connecting terminal 10, the back surface conductor 11, the via conductor 12 and the side surface conductor 17 are made of W or Mo. An exposed surface of each of the electrode pad 9, the external connecting terminal 10, the back surface conductor 11 and the side surface conductor 17 is coated with a gold layer (not shown) having a substantially even thickness through a nickel layer, as an undercoating layer, having a substantially even thickness.

As shown in Fig. 1B, an electronic component 14 such as a capacitor is mounted on the electrode pads 9 in the cavity 6, and afterwards, an inside of the cavity 6 including a space around the electronic component 14 is filled with a liquid-component containing electrolyte (hereinafter, simply called an electrolyte) 16 such as a liquid electrolyte or a gel electrolyte.

An opening of the cavity 6 after filling the electrolyte 16 is externally sealed with, for instance, a ceramic or metal cover (not shown).

Fig. 2A is a plan view of a package 1b according to an embodiment which is different from the above package 1a. Fig. 2B is a cross section vertically cut by a plane passing through a B-B line of Fig. 2A.

As shown in Figs. 2A and 2B, in the same manner as the above package 1a, the package 1b has the same substrate body 2 having the same stacked ceramic layers c1 and c2 and the same cavity 6. In the package 1b, a pair of electrode pads 9 are formed at a pair of opposing shorter sides respectively on the bottom surface 7 of the cavity 6. Further, a pair of external connecting terminals 10 are formed on the back surface 4 of the substrate body 2 at a pair of shorter sides in plan view below the respective electrode pads 9. Also, a pair of recessed portions 18 are formed at the pair of opposing shorter sides respectively in plan view with the recessed portions 18 located or extending from the side surfaces 5 that form the pair of shorter sides to the back surface 4 of the substrate body 2. On recessed inner wall surfaces of the recessed portions 18, the side surface conductors 17 are formed, and the back surface-side end portions of the side surface conductors 17 are connected to respective side surface-side end portions of the pair of external connecting terminals 10.

As shown in Fig. 2B, in the case of the package 1b, the same electronic component 14 is mounted in the cavity 6, and afterwards, a space around the electronic component 14 is filled with the same electrolyte 16, then the opening of the cavity 6 is sealed as appropriate.

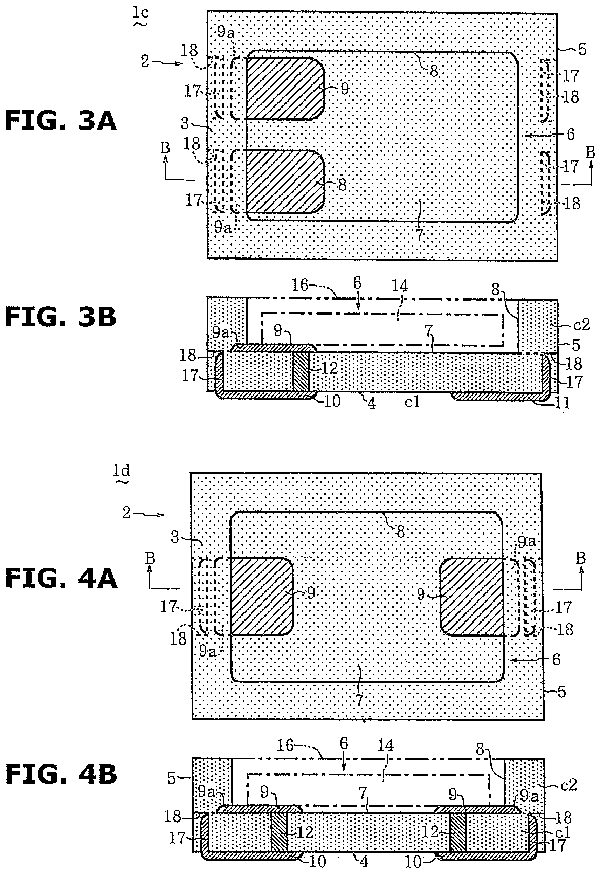

Fig. 3A is a plan view of a package 1c according to an application embodiment of the package 1a. Fig. 3B is a cross section vertically cut by a plane passing through a B-B line of Fig. 3A.

As shown in Figs. 3A and 3B, in the same manner as the above package 1a, the package 1c has the same substrate body 2, the same cavity 6, the same pair of external connecting terminals 10, the same pair of back surface conductors 11, the same four side surface conductors 17, the same pair of via conductors 12 and the same four recessed portions 18.

A different point of the package 1c from the package 1a is a structure in which each of the pair of electrode pads 9 formed along the left shorter side on the bottom surface 7 of the cavity 6 has, as a part of the electrode pad, an entry portion 9a between the ceramic layers c1 and c2 that form the substrate body 2. Here, the ceramic layers c1 and c2 are firmly connected to each other even at an outer peripheral side of each entry portion 9a (even at an outer side of a periphery of each entry portion 9a) .

Fig. 4A is a plan view of a package 1d according to an application embodiment of the package 1b. Fig. 4B is a cross section vertically cut by a plane passing through a B-B line of Fig. 4A.

As shown in Figs. 4A and 4B, in the same manner as the above package 1b, the package 1d has the same substrate body 2, the same cavity 6, the same pair of external connecting terminals 10, the same pair of side surface conductors 17, the same pair of via conductors 12 and the same pair of recessed portions 18.

A different point of the package 1d from the package 1b is a structure in which each of the pair of electrode pads 9 formed at the pair of opposing shorter sides respectively on the bottom surface 7 of the cavity 6 has, as a part of the electrode pad, an entry portion 9a between the ceramic layers c1 and c2 that form the substrate body 2. Here, the ceramic layers c1 and c2 are firmly connected to each other even at an outer peripheral side of each entry portion 9a (even at an outer side of a periphery of each entry portion 9a).

In the case of the ceramic packages 1a and 1b, the electrode pad 9 and the external connecting terminal 10 are electrically connected to each other only through the via conductor 12, and the ceramic layers c1 and c2 are directly connected to each other at an outer peripheral side of the bottom surface 7 of the cavity 6 on the same plane as the bottom surface 7. Further, the electrode pad 9 and the side surface conductor 17 are separate from each other, and these electrode pad 9 and side surface conductor 17 are not directly connected. As a result, a situation in which a leakage path caused by corrosion due to the electrolyte 16 is generated at the side surface of the substrate body 2 can be avoided or suppressed. It is therefore possible to prevent the electrolyte 16, which fills the cavity 6 so as to surround the electronic component 14 mounted in the cavity 6, from leaking to an outside portion of the side surface 5 etc. of the substrate body 2.

Further, this can ensure reliability of the electronic component 14 such as the capacitor mounted on the electrode pads 9 provided on the bottom surface 7 of the cavity 6.

In addition, since the side surface-side end portion of the external connecting terminal 10 and the back surface-side end portion of the side surface conductor 17 are connected to each other, connecting reliability when mounting the ceramic packages 1a and 1b on respective printed boards can be adequately ensured.

Hence, the ceramic packages 1a and 1b can obtain the above-mentioned effects (1) to (3) and (5).

As for the ceramic packages 1c and 1d, since the electrode pad 9 has, as a part of the electrode pad, the entry portion 9a, even the electrode pad 9 having a relatively large area in plan view can be easily placed on the bottom surface 7 of the cavity 6 and at the peripheral side of the bottom surface 7. This can consequently contribute to reduction in whole size of the ceramic packages 1c and 1d, and also degree of flexibility in position of the via conductor 12 electrically connected to the external connecting terminal 10 provided on the back surface 4 of the substrate body 2 can be increased.

Hence, in addition to the above-mentioned effects (1) to (3) and (5), the ceramic packages 1c and 1d can further obtain the effect (4).

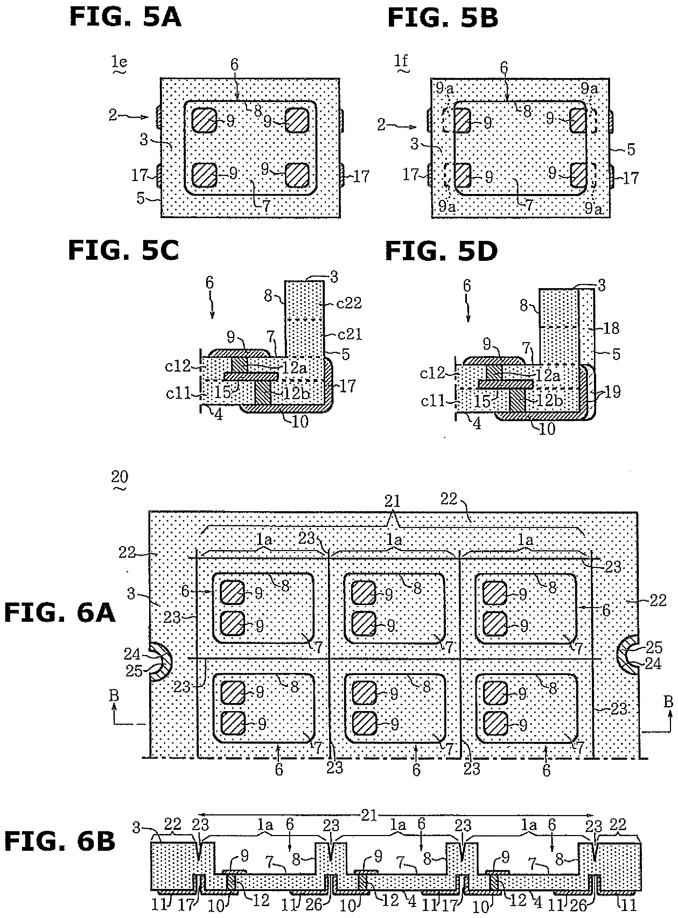

Figs. 5A and 5B are plan views of ceramic packages 1e and 1f according to embodiments that are different from the above embodiments.

As shown in Fig. 5A, in the same manner as the above packages, the ceramic package 1e has the same substrate body 2 and the same cavity 6. Four electrode pads 9 are individually formed at four corner sides on the bottom surface 7 of the cavity 6, and four external connecting terminals 10 (not shown) are formed on the back surface 4 of the substrate body 2 below the respective electrode pads 9 in the same manner as the above. Side surface-side end portions of the external connecting terminals 10 are connected to respective back surface-side end portions of two pairs of side surface conductors 17, i.e. four side surface conductors 17 in total, which are directly formed one pair by one pair on the pair of right and left side surfaces 5 as shown in Fig. 5A.

Hence, the ceramic package 1e can obtain the above-mentioned effects (1) and (2).

On the other hand, as shown in Fig. 5B, in the same manner as the above package 1e, the ceramic package 1f has the same substrate body 2, the same cavity 6, the same four electrode pads 9, the same four external connecting terminals 10 (not shown) and the same four side surface conductors 17. A different point of the package 1f from the package 1e is a structure in which, as shown in the drawing, each of the four electrode pads 9 formed at the four corner sides on the bottom surface 7 of the cavity 6 has, as a part of the electrode pad, an entry portion 9a that extends between the ceramic layers c1 and c2.

Hence, the ceramic package 1f can obtain the above-mentioned effects (1) to (4).

Figs. 5C and 5D are local sectional views showing vertically-cut substrate bodies 2 according to other embodiments. As can be seen in the drawings, the lower layer-side ceramic layer c1 is formed by ceramic layers c11 and c12, and the upper layer-side ceramic layer c2 is formed by ceramic layers c21 and c22. Further, an internal layer wiring 15 is formed between the lower layer-side ceramic layers c11 and c12. As a consequence, the electrode pad 9 formed at the inner side surface 8 side on the bottom surface 7 of the cavity 6 and the external connecting terminal 10 formed on the back surface 4 below the electrode pad 9 can be electrically connected to each other through two upper and lower via conductors 12a and 12b.

Hence, since degree of flexibility in design for plan view arrangement of the electrode pad 9 and the external connecting terminal 10 can be further increased, in addition to the above-mentioned effects (1) to (3) and (5), these embodiments can further obtain the effect (6) .

Here, as shown in Fig. 5D, a recessed portion 18 having a semicircular shape or a semi-oval shape in plan view could be formed on the side surface 5 of the substrate body 2 throughout its length in a vertical direction. Further, a side surface conductor 19 having a semi-arc shape or a semi-long arc shape in plan view and connected to the side surface-side end portion of external connecting terminal 10 could be formed at the back surface 4 side on an inner wall surface of the recessed portion 18.

Furthermore, the electrode pad 9 in the Figs. 5C and 5D could be provided with, as a part of the electrode pad, the above entry portion 9a that extends between the ceramic layers c12 and c21. In this case, these embodiments can obtain the above-mentioned effects (1) to (6).

Fig. 6A is a local plan view of a mother package (a large-sized package) 20 having a plurality of ceramic packages 1a. Fig. 6B is a cross section vertically cut by a plane passing through a B-B line of Fig. 6A.

As shown in the drawings, the mother package 20 is formed by stacking the ceramic layers c1 and c2, and has a product region 21 having a front surface 3 and a back surface 4 which are rectangular in shape in plan view and a plurality of packages 1a that are adjacently arranged laterally and longitudinally in the middle of the product region 21 and ear sections 22 forming a rectangular frame shape in plan view and enclosing the product region 21.

At boundaries between the product region 21 and the ear sections 22 and between the adjacent packages 1a in the product region 21 on the front surface 3 side, lattice frame-shaped dividing grooves 23 forming a lattice shape in plan view and each having a narrow V-shape in vertical cross section are formed.

Further, as shown in Fig. 6A, depressed portions 24 having a semicircular shape in plan view are formed on outer side surfaces of the right and left ear sections 22. Also, plating electrodes 25 having a semi-arc shape in plan view are formed along inner wall surfaces of the depressed portions 24. The plating electrode 25 is also made of W or Mo.

Here, each of the plating electrodes 25 is electrically connected to the via conductor 12 or the internal layer wiring 15 through a plating wiring (not shown) that is formed between the ceramic layers c1 and c2.

Furthermore, as shown in Fig. 6B, hollow portions 26 that are rectangular in shape in plan view and open on a back surface 4 of the mother package 20 are formed on the back surface 4 below the respective dividing grooves 23, and the side surface conductors 17 are individually formed on right and left inner wall surfaces in the drawing. Each of the side surface conductors 17 is connected to the external connecting terminal 10 or the back surface conductor 11. That is, when the mother package 20 is divided into single pieces along the dividing grooves 23, each hollow portion 26 is divided into the pair of recessed portions 18.

According to the mother package 20 having a plurality of ceramic packages, it is possible to provide a plurality of ceramic packages 1a efficiently (an effect (7)).

Here, the packages 1b to 1d can also be provided by the respective mother packages having the same structure or configuration as that of the mother package 20.

Additionally, the packages having the electrode pads 9 at four corner sides on the bottom surface 7 of the cavity 6 as shown in Figs. 5A and 5B and the recessed portion 18 and the side surface conductor 19 at the side surface 5 of the package body 2 as shown in Fig. 5D can also be provided by the respective mother packages having the same structure or configuration as that of the mother package 20.

The present invention is not limited to the embodiments explained above.

For instance, the ceramic layer cx could be made of glass-ceramic. In this case, as the conductor of the electrode pad 9, the external connecting terminal 10, the via conductor 12, the side surface conductor 17 etc., Cu or Ag is used.

Further, any number of electrode pads 9 could be formed on the bottom surface 7 of the cavity 6 as long as at lease the pair of electrode pads 9 are provided (i.e. as long as the electrode pads 9 are two or more in number) .

Furthermore, in the packages 1a and 1c, other side surface conductors 17 could be further formed at the side surface 5 (the right side surface 5 in Figs. 1 and 3) that is opposite side to the side surface 5 where the side surface conductors 17 are already formed, and other external connecting terminals 10 having side surface-side end portions connected to back surface-side end portions of the other side surface conductors 17 could be formed at the right side on the back surface 4. In this case, electrode pads 9 corresponding to these right-side external connecting terminals 10 are not necessarily arranged above these right-side external connecting terminals 10.

Moreover, the whole one electrode pad 9 could be formed on the bottom surface 7 of the single cavity 6, and the other electrode pad 9 could be provided with, as a part of the electrode pad, the entry portion 9a that extends between the ceramic layers c1 and c2.

In addition, a side surface conductor having a square bracket shape fitted to three inner wall surfaces of the recessed portion 18 of the packages 1a to 1d could be formed.

Additionally, a plurality of cavities 6 could open on the front surface 3 of the substrate body 2, and at least a pair of electrode pads 9 could be formed in each cavity 6. Then, the external connecting terminals 10 and the side surface conductors 17 connected to these external connecting terminals 10 could be formed on the back surface 4 below the respective electrode pads 9 and at the adjacent side surfaces 5 respectively.

### INDUSTRIAL APPLICABILITY

According to the present invention, it is possible to surely provide a ceramic package for filling a liquid-component containing electrolyte which is resistant to the development of a corroded portion, caused by contact of the electrolyte with a metal part, to an outer side of a cavity even though the liquid-component containing electrolyte fills the cavity.

### EXPLANATION OF REFERENCE

- 1a to 1f ···: package
- 2 ···: substrate body
- 3 ···: front surface
- 4 ···: back surface
- 5 ···: side surface
- 6 ···: cavity
- 7 ···: bottom surface
- 8 ···: inner side surface
- 9 ···: electrode pad
- 9a ···: entry portion
- 10 ···: external connecting terminal
- 12, 12a, 12b ···: via conductor
- 14 ···: electronic component
- 15 ···: internal layer wiring
- 16 ···: electrolyte
- 17, 19 ···: side surface conductor
- C1, c2 ···: ceramic layer

## Claims

1. A ceramic package for filling a liquid-component containing electrolyte, the ceramic package comprising:
a substrate body formed by stacking a plurality of ceramic layers and having a front surface and a back surface that are located at opposite sides to each other and a side surface that is positioned between the front and back surfaces;
a cavity opening on the front surface of the substrate body and having a bottom surface and an inner side surface;
an electrode pad formed on the bottom surface of the cavity;
an external connecting terminal formed on the back surface of the substrate body;
an electronic component mounted on the electrode pad; and
the liquid-component containing electrolyte filling an inside of the cavity including a space around the electronic component, and wherein
the electrode pad and the external connecting terminal are electrically connected to each other through a via conductor that penetrates, in a thickness direction, a single or a plurality of ceramic layers forming the bottom surface of the cavity and the back surface of the substrate body,
a side surface conductor that extends to a back surface-side end portion of the side surface is provided on the side surface of the substrate body,
the external connecting terminal extends to a side surface-side end portion of the back surface of the substrate body, and the back surface-side end portion of the side surface conductor and the side surface-side end portion of the external connecting terminal are connected to each other, and
the electrode pad and the side surface conductor are separate from each other.

2. The ceramic package for filling the liquid-component containing electrolyte as claimed in claim 1, wherein:
the electrode pad has, as a part of the electrode pad, an entry portion that extends between a lower layer-side ceramic layer forming the bottom surface of the cavity and an upper layer-side ceramic layer stacked on the lower layer-side ceramic layer, and
the lower layer-side ceramic layer and the upper layer-side ceramic layer are directly connected to each other at an outer peripheral side, in plan view, of the entry portion except the entry portion.

3. The ceramic package for filling the liquid-component containing electrolyte as claimed in claim 1 or 2, wherein:
the cavity is rectangular in shape in plan view, and
a pair of electrode pads are formed at one side of the cavity, or a pair of electrode pads are formed at opposing two sides of the cavity respectively.

4. The ceramic package for filling the liquid-component containing electrolyte as claimed in any one of the preceding claims 1 to 3, wherein:
the substrate body has an internal layer wiring that is formed between a lower layer-side ceramic layer forming the bottom surface of the cavity and a lowermost ceramic layer forming the back surface of the substrate body, and
the via conductor is connected to the electrode pad and the external connecting terminal through the internal layer wiring.
